Europäisches Patentamt

European Patent Office

Office européen des brevets

(11) Publication number: **0 188 059 B1**

# EUROPEAN PATENT SPECIFICATION

(45) Date of publication of patent specification: **25.03.92**  (51) Int. Cl.⁵: **G11C 7/00**, G06F 12/00, G09G 1/02

(21) Application number: **85307600.8**

(22) Date of filing: **22.10.85**

(54) **Semiconductor memory device having read-modify-write configuration.**

(30) Priority: **23.10.84 JP 221165/84**

(43) Date of publication of application:
**23.07.86 Bulletin 86/30**

(45) Publication of the grant of the patent:
**25.03.92 Bulletin 92/13**

(84) Designated Contracting States:
**DE FR GB**

(56) References cited:
| | |
|---|---|
| EP-A- 0 040 001 | EP-A- 0 056 240 |
| WO-A-82/02615 | AT-B- 334 662 |
| US-A- 4 272 829 | US-A- 4 276 609 |
| US-A- 4 422 161 | US-A- 4 429 375 |

(73) Proprietor: **FUJITSU LIMITED**
**1015, Kamikodanaka Nakahara-ku**
**Kawasaki-shi Kanagawa 211(JP)**

(72) Inventor: **Ogawa, Junji**
**8-17-207, Minamisenzoku 1-chome Ota-ku**
**Tokyo 145(JP)**

(74) Representative: **Billington, Lawrence Emlyn et al**
**HASELTINE LAKE & CO Hazlitt House 28**
**Southampton Buildings Chancery Lane**
**London WC2A 1AT(GB)**

## Description

The present invention relates to a semiconductor memory device, more particularly, to a semiconductor memory device for performing high speed read-modify-write (hereinafter referred to as RMW) operations on a large amount of data.

Demand has arisen for effectively writing image data in or reading image data from an image processing memory or the like and for effectively performing a high-speed RMW operation, i.e., the storage contents are read out from the memory, the read out data is modified, and the modified data is restored in the memory. A typical RMW application is exemplified by color inversion for inverting a color currently displayed on a display unit in a given relationship, and by pattern emphasis for emphasizing a specific pattern.

A conventional RMW scheme is applied in such a manner that data is read out by using an RMW function of a dynamic-random access memory (D-RAM) device, the read out data is modified by an external circuit, and the modified data is restored in the corresponding memory cell. However, the conventional RMW scheme requires a relatively long processing time defined by the operating cycle of the D-RAM device, resulting in inconvenience.

WO-A-82/2615 discloses a semiconductor memory device in accordance with the precharacterising portions of the accompanying claims 1, 2 and 4.

EP-A-0 056 240 discloses a memory device for performing digital delay processing, which allows serial access mode operation wherein the memory contents of part or a whole row of cells are read out sequentially. A shift register is arranged parallel to a column decoder for performing such a serial readout, and the column decoder is operable to select the point along the shift register where readout is to begin.

Neither of the above documents discloses a semiconductor device for performing high-speed RMW operations.

According to one aspect of the present invention, there is provided a semiconductor memory device comprising:-

a random access memory cell array including a plurality of memory cells; and

register means comprising at least one register circuit array and a data input and output circuit for parallel data transfer between the register circuit array and said memory cells, and further comprising a serial data input and a serial data output;

characterised in that:-

said register means comprise a first register circuit array for reading data from said memory cells, and a second register circuit array for writing data to said memory cells;

data modification means are provided for modifying, in a predetermined logical operation, data from the serial data output of said register means;

the serial data output of the register means being connected to an input of the data modification means via transfer means, and an output of the data modification means being connected to the serial data input of the register means;

whereby, in use, data transfer from and to said register means can be carried out simultaneously to effect a high-speed read-modify-write operation.

According to a second aspect of the invention, there is provided a semiconductor memory device comprising:-

a random access memory cell array including a plurality of memory cells; and

register means comprising a register circuit array and a data input and output circuit for parallel data transfer between the register circuit array and said memory cells, and further comprising a serial data input and a serial data output;

characterised in that:-

data modification means are provided for modifying, in a predetermined logical operation, data from the serial data output of said register means, the serial data output of the register means being connected to an input of the data modification means via transfer means and an output of the data modification means being connected to the serial data input of the register means;

and in that said transfer means comprise an output gate array, a pointer register circuit array and a data bus, the output gate array comprising gates connected between respective register circuits of the register means and said data bus and controlled by said pointer register circuit array;

whereby, in use, data transfer from and to said register means can be carried out simultaneously to effect a high-speed read-modify-write operation.

According to a development of the second aspect of the invention, there is provided a semiconductor memory device, wherein the data modification means comprises a plurality of modification circuits provided in parallel, and wherein the register means is in the form of a plurality of shift registers provided one or more for each respective modification circuit, each modification circuit having individual data transfer means connecting it to its respective shift register, whereby high-speed read-write-modify operations may be carried out in parallel by each modification circuit.

According to a third aspect of the invention there is provided a semiconductor memory device comprising:-

a random access memory cell array including a plurality of memory cells; and

register means comprising a register circuit array and a data input and output circuit for parallel data transfer between the register circuit array and said memory cells;

characterised in that:-

data modification means are provided for modifying, in a predetermined logical operation, data from said register circuit array;

said register circuit array is an array of latches each operable to supply data to a first data bus and to receive data from a second data bus, said first and second data buses being connected to an input and an output of said data modification means, respectively, via data transfer means;

said data transfer means comprising a first array of gates, having gates in a one-to-one correspondence with said latches, for transferring data from the latches to said first data bus under control of a control register array, and a second array of gates having gates in a one-to-one correspondence with said latches, for transferring data from said second data bus to said latches under control of said control register array;

whereby, in use, data transfers from and to said array of latches can be carried out simultaneously to effect a high-speed read-modify-write operation.

An embodiment of the present invention can provide a semiconductor memory device for performing a high-speed RMW operation of a large amount of data for selected memory cells.

The device may include a circuit for designating a predetermined range of data output from the data output circuit and data restore in the data input and output circuit, to perform a predetermined range of data modification.

Reference is made, by way of example, to the accompanying drawings, in which:

Fig. 1 is a block diagram of a semiconductor memory device according to an embodiment of the present invention;

Fig. 2 is a circuit diagram of shift registers in the device shown in Figure 1;

Fig. 3 is a timing chart for explaining the operation of the shift registers shown in Fig. 2;

Fig. 4 is a circuit diagram of a modifying circuit in the device shown in Fig. 1;

Fig. 5a to 5c are circuit diagrams showing modifications of the circuit of Fig. 4, respectively;

Fig. 6 is a block diagram of a semiconductor memory device according to another embodiment of the present invention;

Fig. 7 is a circuit diagram showing connections between the shift register and a data bus in the device shown in Fig. 6;

Fig. 8 is a timing chart for explaining the operation of the circuit arrangement shown in Fig. 7;

Fig. 9 is a circuit diagram of pointer shift registers in the device of Fig. 6;

Fig. 10 is a timing chart for explaining the operation of the registers shown in Fig. 9;

Fig. 11 is a circuit diagram showing a mnodification of the device shown in Fig. 6;

Figs. 12 and 14 are block diagrams of semiconductor memory devices according to still other embodiments of the present invention; and

Fig. 13 is a block diagram of a semiconductor memory device not according to the present invention.

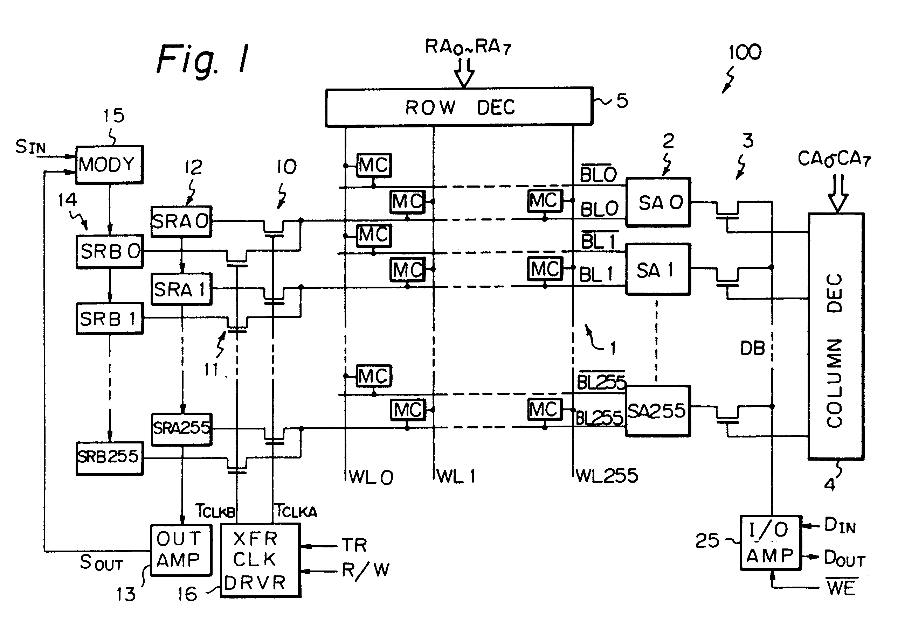

Figure 1 is a block diagram of a semiconductor memory device according to a first embodiment of the present invention.

The semiconductor memory device in Fig. 1 has a plurality of dynamic RAM (D-RAM) cells (MC) 1 arranged in a matrix form, a row decoder 5 for selecting word lines $WL_0$ to $WL_{255}$ of the memory cells in response to row address signals $RA_0$ to $RA_7$ , a sense amplifier array 2 of sense amplifiers $SA_0$ to $SA_{255}$ connected to bit lines $BL_0$ to $BL_{255}$ and $\overline{BL_0}$ to $\overline{BL_{255}}$ , a gate array 3 including 256 gates, a column decoder 4 for selecting one of the gates constituting the gate array 3 in accordance with column address signals $CA_0$ to $CA_7$ , a data bus DB connected to one gate of the gate array 3 which is selected by the column decoder 4, and an I/O amplifier 25 connected to the data bus DB. This arrangement is the same as a conventional D-RAM configuration. The same operation as in a conventional D-RAM device can be also applied to the semiconductor memory device of the first embodiment. It should be noted that the D-RAM device of the first embodiment has a memory capacity of 64 kbits ( = 256 bits x 256 bits).

The semiconductor memory device in Fig. 1 further has a data read shift register array 12 including 256 series-connected shift registers $SRA_0$ to $SRA_{255}$ connected to the bit lines $BL_0$ to $BL_{255}$ through a first transfer gate array 10 including 256 transfer gates, and a data write shift register array 14 having 256 series-connected shift registers $SRB_0$ to $SRB_{255}$ and connected to the bit lines $BL_0$ to $BL_{255}$ through a second transfer gate array 11 including 256 transfer gates. An output amplifier 13 is connected to the read shift register array 12. An output signal $S_{OUT}$ from the output amplifier 13 is supplied together with a modifying input signal $S_{IN}$ from a central processor unit (CPU), not shown, to a modifying circuit 15. An output signal from the modifying circuit 15 is supplied to the write shift register array 14.

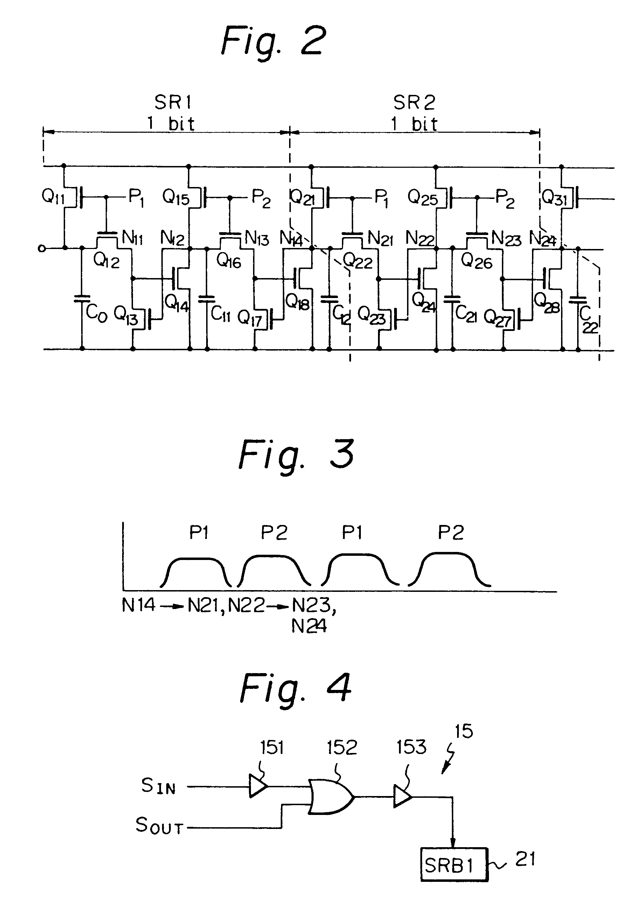

A typical example of the read and write shift registers $SRA_0$ to $SRA_{255}$ and $SRB_0$ to $SRB_{255}$ of Fig. 1 is a two-phase ratio type shift register as shown in Fig. 2. A timing chart of the two-phase ratio type shift register is illustrated in Fig. 3. In the shift register $SR_2$ , a value at a node $N_{14}$ of the preceding step of the shift register $SR_1$ is trans-

ferred as master data, and a transistor $Q_{22}$ is turned ON in response to a clock pulse $P_1$ to receive the master data in a node $N_{21}$. When a voltage level at the node $N_{21}$ is set at logic "1", the level at a node $N_{22}$ is inverted. In order to perform a slave transfer, a transistor $Q_{26}$ is turned ON in response to a clock pulse $P_2$ to set the level at a node $N_{23}$ to be equal to that at the node $N_{22}$. The signal level at a node $N_{24}$ is inverted in accordance with the signal level at the node $N_{23}$. Therefore, the data can be shifted bit by bit in each shift register.

The operation of the semiconductor memory device in Fig. 1 will be described hereinafter. The D-RAM side is asynchronized with the shift register side and may be operated independently thereof. The D-RAM can be accessed in a conventional manner. At the same time, when the D-RAM is held in a nonaccess mode, an RMW operation can be performed in the following manner.

In the RMW mode, a transfer instruction TR and a read instruction R/W = 0 are supplied to a transfer clock driver 16, and the driver 16 generates a clock signal $T_{CLKA}$. The transfer gate array 10 is turned ON in response to the clock signal $T_{CLKA}$, so that data, on the bit lines $BL_0$ to $BL_{255}$ connected to the accessed word line $WL_i$, is simultaneously supplied to the read shift register array 12. The data in the shift register array 12 is then consecutively read as an output signal $S_{OUT}$ by the output amplifier 13, supplying the read signal $S_{OUT}$ to the modifying circuit 15.

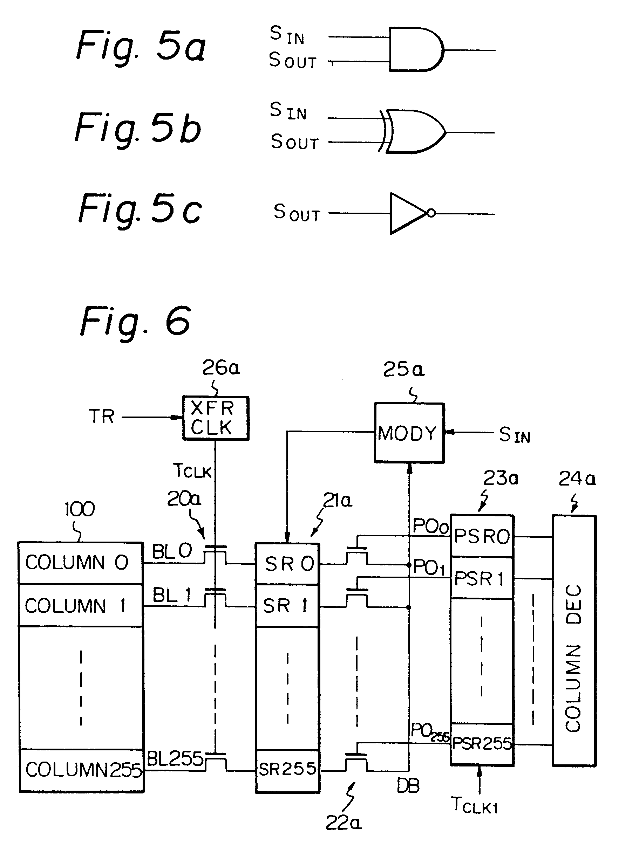

As shown in Fig. 4, the modifying circuit 15 for example includes an amplifier 151 for amplifying the input signal $S_{IN}$, an OR gate 152 for producing a logical OR of the signals $S_{IN}$ and $S_{OUT}$, and an amplifier 153 for amplifying an output from the OR gate 152. The original signal as the signal $S_{OUT}$ is logically ORed with the input signal $S_{IN}$ in the circuit of Fig. 4. However, the data modification is not limited to a logic sum (OR), but can be extended to a logic product (Fig. 5a), a logical exclusive OR (Fig. 5b) or a simple inversion (Fig. 5c) and so on.

The modified signal is stored in the write shift register array 14. When the modified signals are loaded in to all the shift registers, the transfer instruction TR and the write instruction R/W = 1 are supplied to the transfer clock driver 16. The gate array 11 is turned ON in response to the clock signal $T_{CLKB}$ from the driver 16. The contents in the shift register array 14 are stored in the memory cells connected to the above-mentioned word line $WL_i$.

In this case, when the data in the memory cells is to be used for only display, an output amplifier (not shown) connected to the end stage $SRB_{255}$ of the shift register array 14 may serially output the data to be displayed on the display unit while the gate array 11 is kept OFF.

As described above, a simultaneous high-speed RMW operation can be performed for memory cells connected to a given word line.

In the above embodiment, two shift register arrays are used for the RMW operation.

The semiconductor memory devices mentioned above perform an RMW operation for all shift registers (all bit lines). In general, however, an RMW operation is desired to be performed for desired bit lines. An embodiment suitable for this application will be described hereinafter.

Figure 6 shows an arrangement of a semiconductor memory device according to a second embodiment of the present invention. Reference numeral 100 denotes a circuit corresponding to the D-RAM device (Fig. 1) including the memory cell array 1, the sense amplifier array 2, the gate array 3, the column decoder 4, the row decoder 5, and the I/O amplifier 25 so as to schematically show the connections between the respective components with the bit lines in units of columns.

A shift register array 21a is connected to the bit lines $BL_0$ to $BL_{255}$ through a transfer gate array 20a including 256 transfer gates. The output terminals of the shift register array 21a are connected to the corresponding input terminals of an output gate array 22a including 256 gates, i.e., transistors. The drains of the transistors of the output gate array 22a are connected to a data bus DB. The data bus DB is connected to a modifying circuit 25a. A pointer shift register (PSR) array 23a is arranged to control the respective gates of the output gate array 22a. A column decoder 24a is arranged to set a value in the pointer shift register array 23a.

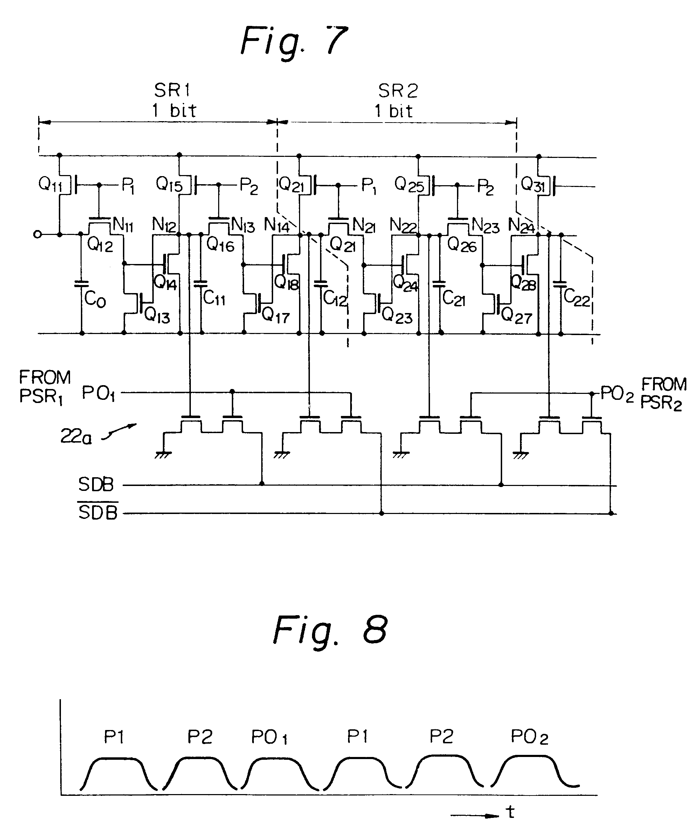

Each shift register in the shift register array 21a may be the same as that shown in Fig. 3. One arrangement representing the connections between the shift registers $SR_1$ and $SR_2$, the output gate 22a, and the $PSR_1$ and $PSR_2$ is shown in Fig. 7. The timing chart of the arrangement of Fig. 7 is shown in Fig. 8. The data is shifted bit by bit in response to the clock signals P1 and P2 in the same manner as in the first embodiment. According to the second embodiment, in addition, the contents in the shift registers appear on the data bus DB consisting of data buses SDB and $\overline{SDB}$ in response to a pointer instruction signal $PO_i$ from the pointer shift register array 23a.

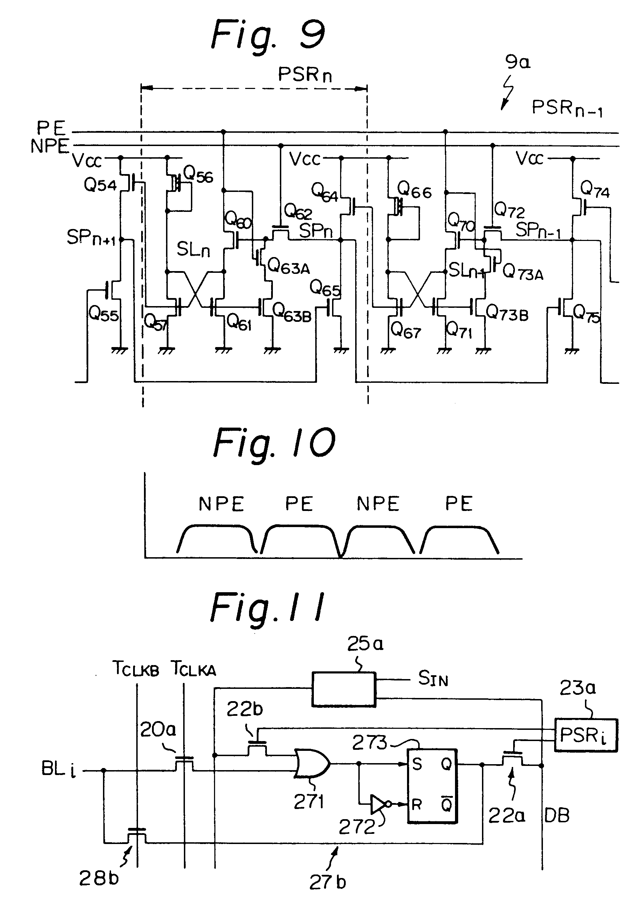

Figure 9 is a circuit diagram of part of an example pointer shift register array 23a. The n-th pointer shift register $PSR_n$ consists of a depletion-type transistor $Q_{56}$ and enhancement-type transistors $Q_{57}$ and $Q_{60}$ to $Q_{65}$. Other pointer shift registers are applied (constructed) in the same way. Figure 10 illustrates waveforms of a clock signal $T_{CLK1}$ for driving the pointer shift register array 23a. The clock pulse signal $T_{CLK1}$ shown in Fig. 10 for driving the pointer shift registers includes a first pulse PE and a second pulse NPE, which are phase-shifted by 180° from each other.

The operation of the pointer shift registers will now be described. First, when the pulse PE is high level, it is assumed that an output $SL_{n-1}$ at the (n-1)-th pointer shift register $PSR_{n-1}$ is high level or logical "1", and all other outputs $SL_0$ to $SL_{n-2}$ and $SL_n$ to $SL_{255}$ are low level or logical "0". Due to the application of a high level voltage of the output $SL_{n-1}$, the transistor $Q_{64}$ in the n-th pointer shift register $PSR_n$ is turned ON, with a resultant charging-up of a node $SP_n$ to a high level. By applying a high level signal at the node $SP_n$ to a gate of a transistor $Q_{75}$ in the pointer shift register $PSR_{n-1}$, the transistor $Q_{75}$ is turned ON, resulting in a low level at the node $SP_{n-1}$. The states at the node $SP_n$ and $SP_{n-1}$ are maintained as is when the pulse PE becomes low. When the pulse NPE becomes high, the transistors $Q_{62}$ and $Q_{72}$ are turned ON, applying a high level signal at the node $SP_n$ to a gate of the transistor $Q_{60}$ and a low level signal at the node $SP_{n-1}$ to a gate of the transistor $Q_{70}$. The signals applied to the respective gates of the transistors $Q_{60}$ and $Q_{70}$ are maintained if the pulse NPE becomes low. Again, by applying a pulse PE having a high level to the pointer shift registers $PSR_n$ and $PSR_{n-1}$, the signal levels at nodes $SL_n$ and $SL_{n-1}$ are respectively rendered high and low. As a result, unique "1" bit data (a single "1" bit) is transferred from the pointer shift register $PSR_{n-1}$ to the adjacent pointer shift register $PSR_n$.

The transistors $Q_{73A}$ and $Q_{73B}$ prevent the application of a high voltage to a gate of the transistor $Q_{70}$, to securely maintain the node $SL_{n-1}$ at the low level. As the gate of the transistor $Q_{60}$ is supplied with a sufficiently high voltage, the gate voltage of the transistor $Q_{63B}$ is rapidly rendered to the low level together with the change of the node $SL_n$ to a high level.

The transistors $Q_{56}$, $Q_{57}$, and $Q_{61}$ in the pointer shift register $PSR_n$ and the transistors $Q_{66}$, $Q_{67}$, and $Q_{71}$ are used for preventing malfunctions which may arise due to the floating signal level, i.e., low level, because many nodes SL are low level. The depletion transistors $Q_{56}$ and $Q_{66}$ may be replaced by resistors.

By applying one clock signal $T_{CLK1}$ consisting of the pair of pulses PE and NPE to the pointer shift register array 23a, 1 bit data held in one pointer shift register is transferred to the next pointer shift register and that one pointer shift register is reset. This is successively effected in response to application of the clock signal $T_{CLK1}$. The pointer shift registers $PSR_0$ to $PSR_{255}$ feature a unique "1" bit shift therein.

In this embodiment, an arbitrary amount (number of bits) of serial data appearing on the bit lines between the first bit line $BL_0$ and n-th bit line $BL_{n-1}$ can be successively output via the shift registers $SR_0$ to $SR_{n-1}$ and via the gate 22a, one of which (at a time) is selected in response to the unique "1" bit shift in the pointer shift register array 23a. Via the selected gate 22a, output data successively appear on the data bus DB, which may be output to the exterior of the device via an output amplifier (not shown) so that serial data for a display unit can be obtained. Alternatively, n-th pointer register $PSR_{n-1}$ may be set at logic "1" and held thereat while a desired number of shifts of the shift register array 21a is carried out. This operation also brings about serial data output of the desired number of bits via the data bus DB, but in a reverse direction in the data shift.

A modification circuit 25a may be the same as one of the types of modifying circuit described above.

The RMW operation of the semiconductor memory device according to the second embodiment in Fig. 6 will be described hereinafter.

When a transfer instruction TR is set at logic "1", the gate array 20a is turned ON in response to a clock signal $T_{CLK}$ from the transfer clock driver 26a, so that the data are simultaneously transferred from 256 memory cells defined by the predetermined word line and the bit lines $BL_0$ to $BL_{255}$ to the register array 21a.

In one preferred mode of RMW operation, an output from an arbitrary one of the pointer shift registers $PSR_0$ to $PSR_{255}$ is set at logic "1", and the output gate connected to the "1" holding shift register of the register array 21a is turned ON, while data in the shift registers $SR_0$ to $SR_{n-1}$ is shifted by one bit in response to the clock pulse (not shown). At the same time, the output from the shift register $SR_{n-1}$ appears on the data buses SDB and $\overline{SDB}$. The data on the data buses SDB and $\overline{SDB}$ as reference data is modified by the modifying circuit 25a together with the input signal $S_{IN}$. In the next cycle, the modified value is stored in the shift register $SR_0$, and at the same time the data in the shift registers $SR_0$ to $SR_{n-2}$ is shifted to the shift registers $SR_1$ to $SR_{n-1}$, so that the content of the shift register $SR_{n-2}$ appears on the data buses SDB and $\overline{SDB}$.

The same modification operation as described above is performed for n bits.

In another mode of RMW operation, one of the pointer shift registers $PSR_0$ to $PSR_{255}$ is set at logic "1" and both the shift register arrays 21a and 23a are shifted synchronously. By this operation, n shift registers $SR_0$ to $SR_{n-1}$ are made to store the same data which is a result of the modification of the initially accessed data by the one pointer register by the input signal $S_{IN}$, with the number n corresponding to the number of shifts.

The modified contents need not be restored in the memory cells to update the contents thereof but can be supplied from the shift register array 21a to another device.

As may be apparent from the above description, a high-speed RMW operation can be performed for a predetermined range of 1st to nth bit lines $BL_0$ to $BL_{n-1}$, and the row decoder can be controlled to perform the RMW operation within a predetermined range of word lines.

In the above embodiment, data on the first to n-th bit lines are modified. However, any modification range of $n_1$-th to $n_2$-th bit lines can be selected.

Still another embodiment of the present invention is shown in Fig. 11. In the circuit of Fig. 11, the shift register array 21a in Fig. 6 is replaced with an set-reset (R-S) flip-flop array. More specifically, instead of the shift register, a latch circuit 27b consisting of a flip-flop 273, an OR gate 271, and an inverter 272 is used together with gates 22b and 28b associated with the latch circuit 27b.

In operation, the contents of memory cells on a bit line $BL_i$ are read out and stored in the flip-flop 273 through a gate 20a and the OR gate 271. An output Q of the flip-flop 273 is extracted by a pointer instruction $PO_i$ from the pointer shift register $PSR_i$ onto the data bus DB through the gate 22a. The data on the data bus DB is modified by the modifying circuit 25a. The modified content (data) is stored in a flip-flop 273 through the gate 22b and the OR gate 271. The output Q of the modified and stored content is stored in the memory cell connected to the bit line $BL_i$ through the gate 28b in response to the clock signal $T_{CLKB}$.

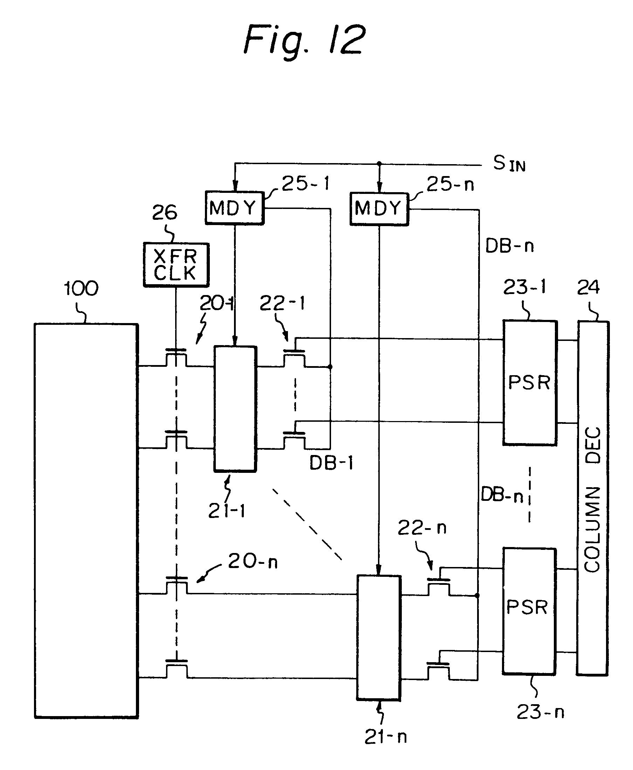

In order to increase the RMW operation speed, an n-parallel RMW arrangement is shown in Fig. 12. The connection between the circuit of Fig. 12 and the memory cell array 100 is the same as described above. However, in order to perform the n-parallel RMW operation, n data buses DB-1 to DB-n and n modifying circuits 25-1 to 25-n are arranged. Furthermore, n pointer register arrays 23-1 to 23-n can be operated in parallel with n register arrays 21-1 to 21-n. The pointer register arrays 23-1 to 23-n and the register arrays 21-1 to 21-n may be shift registers or flip-flops. The modifying circuits 25-1 to 25-n may each be the same as the modifying circuit 15 of Fig. 1. The modifying circuit may include a circuit as shown in Figs. 4 and 5a to 5c or others. The circuits shown in Figs. 4 and 5a to 5c can be selectively used to perform various RMW operations.

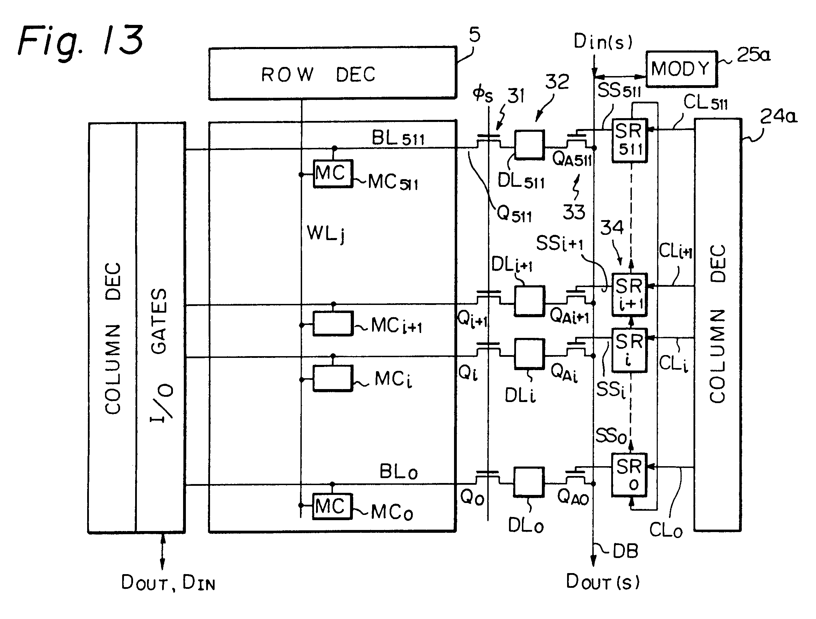

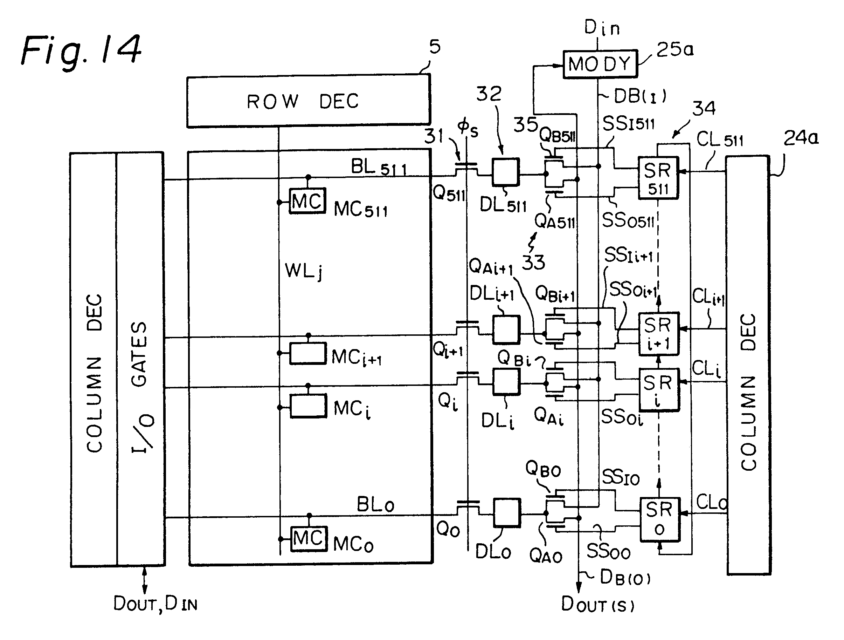

Devices for performing RMW operations for memory cells (m x n) of a specific area are shown in Figs. 13 and 14, respectively.

The circuit in Fig. 13 has a gate array 31 consisting of gates $Q_0$ to $Q_{511}$ each having one end connected to a corresponding one of bit lines $BL_0$ to $BL_{511}$, a latch array 32 consisting of data latches $DL_0$ to $DL_{511}$ each having one end connected to the other end of the corresponding gates $Q_0$ to $Q_{511}$, a gate array 33 consisting of gates $Q_{A0}$ to $Q_{A511}$ each connected to the other end of the corresponding data latches $DL_0$ to $DL_{511}$, and a shift register array 34 consisting of shift registers $SR_0$ to $SR_{511}$ for controlling the gates of the gate array 33. The gate array 33 is connected to the data bus DB to which the modifying circuit 25a is connected. In this device the memory cell array has a 512 x 512 matrix, and other arrangements of the circuit are the same as those of the previous circuit.

The operation of the circuit shown in Fig. 13 will be described.

When the memory cell (DRAM) side is not accessed, a specific word line $WL_j$ is selected by the row decoder 5. When a clock signal $\phi_S$ is enabled, all the gates $Q_0$ to $Q_{511}$ of the gate array 34 are turned ON, so that the contents of the memory cells connected to the word line $WL_j$ are transferred to the data latches $DL_0$ to $DL_{511}$ through the bit lines $BL_0$ to $BL_{511}$ and the gates $Q_0$ to $Q_{511}$. The clock signal $\phi_S$ is disabled after the above-mentioned data transfer period. Thereafter, the memory cells can be accessed.

Among the contents latched by the data latches $DL_0$ to $DL_{511}$, the contents of specific registers for the shift register array 34, e.g., $SR_i$ to $SR_{i+n}$ are subjected to the RMW operation. The shift registers $SR_0$ to $SR_{i-1}$ are kept OFF in response to signals $CL_0$ to $CL_{i-1}$ from the column decoder 24a, and the outputs from the shift registers $SR_0$ to $SR_{i-1}$ are kept OFF. Therefore, the gates $Q_{A0}$ to $Q_{A(i-1)}$ are kept off, and the contents of the data latches $DL_0$ to $DL_{i-1}$ are left unchanged. The shift registers $SR_i$ to $SR_{i+n}$ are sequentially turned ON in response to the signals $CL_i$ to $CL_{i+n}$ from the column decoder 24a. The gates $Q_{Ai}$ to $Q_{A(i+n)}$ are sequentially turned ON in response to the ON outputs $CL_i$ to $CL_{i+n}$. In this case, the input data $D_{in}$ is supplied to the data bus DB, and the contents modified by the modifying circuit 25a are sequentially latched by the data latches $DL_i$ to $DL_{i+n}$. The data latches $DL_{i+n+1}$ to $DL_{511}$ and $DL_0$ to $DL_{i-1}$ store the contents of the memory cells without modification. The modified contents within the range of bit lines $BL_i$ to $BL_{i+n}$ for the word line $WL_j$ are held in the data latches $DL_i$ to $DL_{i+n}$, while other latches store the contents of the memory cells without modification.

In this state, the clock signal $\phi_S$ is enabled for a predetermined period of time while the memory cells are not accessed. The gate array 31 is turned ON, and the contents of the data latch array 32 are stored in the memory cells connected to the word

line WL$_j$. The modified contents can be stored in the memory cells within the range of bit lines BL$_i$ to BE$_{i+n}$. Other memory cells hold the previous data.

The same operations are performed for the word lines WL$_{j+l}$ to WE$_{j+m}$ , and thus high-speed RMW operation can be performed for the specific memory cell area (m x n).

Figure 14 shows an embodiment wherein the gate array 33 in Fig. 13 includes a gate array 35 consisting of gates Q$_{B0}$ to Q$_{B511}$ connected to an input data bus DB(I) and a gate array 33 consisting of gates Q$_{A0}$ to Q$_{A511}$ connected to an output data bus DB(O).

The contents of the memory cells temporarily transferred to data latches DL$_0$ to DL$_{511}$ are modified by the modifying circuit 25a together with the input data D$_{in}$ within the specific range of i to i+n, and the modified contents are latched by the data latches DL$_0$ to DL$_{511}$. The modified contents can be stored in the memory cells during the nonaccess mode of the memory cell array in the same manner as described above.

In this circuit, high-speed RMW operation can be performed for the memory contents for the specific memory cell area (m x n), and the contents of other memory cell areas can be left unchanged.

## Claims

1. A semiconductor memory device comprising:-
   a random access memory cell array (1) including a plurality of memory cells; and
   register means comprising at least one register circuit array (12, 14) and a data input and output circuit (10, 11) for parallel data transfer between the register circuit array and said memory cells, and further comprising a serial data input and a serial data output;
   characterised in that:-
   said register means comprise a first register circuit array (12) for reading data from said memory cells, and a second register circuit array (14) for writing data to said memory cells;
   data modification means (15) are provided for modifying, in a predetermined logical operation, data from the serial data output of said register means;
   the serial data output of the register means being connected to an input of the data modification means (15) via transfer means (13), and an output of the data modification means (15) being connected to the serial data input of the register means;
   whereby, in use, data transfer from and to said register means can be carried out simultaneously to effect a high-speed read-modify-write operation.

2. A semiconductor memory device comprising:-
   a random access memory cell array (100) including a plurality of memory cells; and
   register means comprising a register circuit array (21a; 21-1, ...21-n) and a data input and output circuit (20a; 20-1, ...20-n) for parallel data transfer between the register circuit array and said memory cells, and further comprising a serial data input and a serial data output;
   characterised in that:-
   data modification means (25a; 25-1, ...25-n) are provided for modifying, in a predetermined logical operation, data from the serial data output of said register means (21a; 21-1, ...21-n), the serial data output of the register means being connected to an input of the data modification means (25a; 25-1, ...25-n) via transfer means (22a, 23a, DB; 22-1, ...22-n, 23-1, ...23-n, DB-1 , ...DB-n), and an output of the data modification means being connected to the serial data input of the register means (21a; 21-1, ...21-n);
   and in that said transfer means comprise an output gate array (22a; 22-1, ...22-n), a pointer register circuit array (23a; 23-1, ...23-n) and a data bus (DB; DB-1, ...DB-n), the output gate array comprising gates connected between respective register circuits of the register means (21a; 21-1, ...21-n) and said data bus and controlled by said pointer register circuit array (23a; 23-1, ...23-n);
   whereby, in use, data transfer from and to said register means (21a; 21-1, ...21-n) can be carried out simultaneously to effect a high-speed read-modify-write operation.

3. A semiconductor memory device according to claim 2, wherein the data modification means comprises a plurality of modification circuits (25-1, ...25-n) provided in parallel, and wherein the register means is in the form of a plurality of shift registers (21-1, ...21-n) provided one or more for each respective modification circuit, each modification circuit having individual data transfer means (22-1, ...22-n, 23-1, ...23-n, DB-1, ...DB-n) connecting it to its respective shift register, whereby high-speed read-write-modify operations may be carried out in parallel by each modification circuit.

4. A semiconductor memory device comprising:-
   a random access memory cell array including a plurality of memory cells; and
   register means comprising a register circuit array (32) and a data input and output circuit (31) for parallel data transfer between the register circuit array and said memory cells;

characterised in that:-

data modification means (25a) are provided for modifying, in a predetermined logical operation, data from said register circuit array (32);

said register circuit array (32) is an array of latches each operable to supply data to a first data bus ($DB_{(o)}$) and to receive data from a second data bus ($DB_{(1)}$), said first and second data buses being connected to an input and an output of said data modification means (25a), respectively, via data transfer means;

said data transfer means comprising a first array of gates (33), having gates in a one-to-one correspondence with said latches (32), for transferring data from the latches (32) to said first data bus ($DB_{(o)}$) under control of a control register array (34), and a second array of gates (35) having gates in a one-to-one correspondence with said latches (32), for transferring data from said second data bus ($DB_{(1)}$) to said latches under control of said control register array (34);

whereby, in use, data transfers from and to said array of latches (32) can be carried out simultaneously to effect a high-speed read-modify-write operation.

5. A semiconductor memory device according to any preceding claim, wherein said data input and output circuit (10, 11; 20a; 20-1, ...20-n; 31) comprises at least one set of gates, the gates being connected between respective memory cell selection lines (BL) of the memory cell array (1, 100) and said register circuit array and controlled in common by a gate drive circuit (16; 26a; 26).

6. A semiconductor memory device according to any preceding claim, wherein the data modification means (15; 25a; 25-1 to 25-n; 25a) includes a logical operation circuit for performing a logical operation upon one bit data.

7. A semiconductor memory device according to any preceding claim, wherein the registers of the register means are in the form of one or more shift registers (12, 14; 21a; 21-1, ...21-n).

8. A semiconductor memory device according to any of claims 1 to 6, wherein the registers of the register means are constituted by flip-flops (32).

9. A semiconductor memory device according to claim 1, wherein:-

said data input and output circuit comprises a set of first gates (10) controlled in common by a gate drive circuit (16);

a first register circuit array (12) is constituted by a plurality of registers connected in series;

a terminal of each of said first gates (10) being operatively connected to a corresponding memory cell selection line (BL) and another terminal thereof being connected to a corresponding one of said first registers (12);

in a data transfer mode, each of said first registers (12) being operable independently of each other, said gate drive circuit simultaneously driving said plurality of first gates (10) to simultaneously store a plurality of data of said memory cells into said first registers (12);

in a data output mode, said first registers (12) being operable serially to successively output stored data therein to said transfer means (13).

10. A semiconductor memory device according to claims 2, 3 or 4, wherein the data transfer means (22a, 23a, DB; 22-1, ...22-n, 23-1, ...23-n, DB1, ...DB-n; 33, 35, 34, $DB_{(o)}$ , $DB_{(1)}$) is provided with selecting means (23a; 23-1, ...23-n; 34) operable to select a subset of the registers of the register means, to perform the read-modify-write operation on the data of a predetermined range of memory cells.

11. A semiconductor memory device according to claim 2 or 3, wherein said pointer register circuit array (23a; 23-1, ...23-n) is provided by a shift register which is controlled by a decoder (24a, 24) so as to successively activate the gates of the output gate array (22a; 22-1, ...22-n) in response to a command decoded at said decoder.

**Revendications**

1. Dispositif de mémoire à semiconducteur comprenant:

un réseau de cellules de mémoire à accès sélectif (1) incluant une pluralité de cellules de mémoire; et

des moyens à registres comprenant au moins un réseau de circuits-registres (12,14) et un circuit d'entrée et de sortie de données (10,11) pour transférer des données en parallèle entre le réseau de circuits-registres et lesdites cellules de mémoire, et comprenant en outre une entrée de données en série et une sortie de données en série;

caractérisé en ce que:

lesdits moyens à registres comprennent un premier réseau de circuits-registres (12) pour lire des données dans lesdites cellules de mémoire, et un deuxième réseau de circuits-registres (14) pour écrire des données dans lesdites cellules de mémoire;

des moyens de modification de données (15) sont prévus pour modifier, dans une opération logique prédéterminée, des données provenant de la sortie de données en série desdits moyens à registres;

la sortie de données en série des moyens à registres étant connectée à une entrée des moyens de modification de données (15) par des moyens de transfert (13), et une sortie des moyens de modification de données (15) étant connectée à l'entrée de données en série des moyens à registres;

un transfert de données pouvant ainsi être réalisé, en fonctionnement, simultanément à partir des et vers lesdits moyens à registres pour l'exécution d'une opération de lecture-modification-écriture rapide.

2. Dispositif de mémoire à semiconducteur comprenant:

un réseau de cellules de mémoire à accès sélectif (100) incluant une pluralité de cellules de mémoire; et

des moyens à registres comprenant un réseau de circuits-registres (21a;21-1,...,21-n) et un circuit d'entrée et de sortie de données (20a;20-1,...,20-n) pour un transfert de données en parallèle entre le réseau de circuits-registres et lesdites cellules de mémoire, et comprenant en outre une entrée de données en série et une sortie de données en série;

caractérisé en ce que:

des moyens de modification de données (25a;25-1, ..., 25-n) sont prévus pour modifier, dans une opération logique prédéterminée, des données provenant de la sortie de données en série desdits moyens à registres (21a; 21-1,...,21-n), la sortie de données en série des moyens à registres étant connectée à une entrée des moyens de modification de données (25a;25-1,...,25-n) par des moyens de transfert (22a,23a,DB;22-1,...,22-n,23-1,..., 23-n,DB-1,...,DB-n), et une sortie des moyens de modification de données étant connectée à l'entrée de données en série des moyens à registres (21a;21-1,...,21-n);

et en ce que lesdits moyens de transfert comprennent un réseau de portes de sortie (22a;22-1,...,22-n), un réseau de circuits-registres de pointeur(23a;23-1, ...,23-n) et un bus de données (DB;DB-1,...,DB-n), le réseau de portes de sortie comprenant des portes connectées entre des circuits -registres respectifs des moyens à registres (21a;21-1,...,21-n) et ledit bus de données et commandées par ledit réseau de circuits-registres de pointeur (23a;23-1,...,23-n);

un transfert de données pouvant ainsi être réalisé, en fonctionnement, simultanément à partir des et vers lesdits moyens à registres (21a;21-1,...,21-n) pour l'exécution d'une opération de lecture-modification-écriture rapide.

3. Dispositif de mémoire à semiconducteur selon la revendication 2, dans lequel les moyens de modification de données comprennent une pluralité de circuits de modification (25-1,...,25-n) prévus en parallèle, et dans lequel les moyens à registres sont sous la forme d'une pluralité de registres à décalage (21-1,...,21-n) dont un ou plusieurs sont prévus pour chaque circuit de modification respectif, chaque circuit de modification comportant un moyen de transfert de données individuel (22-1,...,22-n,23-1,...,23-n,DB-1,...,DB-n) le connectant à son registre à décalage respectif, des opérations de lecture-modification-écriture rapides pouvant ainsi être exécutées en parallèle par chaque circuit de modification.

4. Dispositif de mémoire à semiconducteur comprenant:

un réseau de cellules de mémoire à accès sélectif incluant une pluralité de cellules de mémoire; et

des moyens à registres comprenant un réseau de circuits-registres (32) et un circuit d'entrée et de sortie de données (31) pour un transfert de données en parallèle entre le réseau de circuits-registres et lesdites cellules de mémoire;

caractérisé en ce que:

des moyens de modification de données (25a) sont prévus pour modifier, dans une opération logique prédéterminée, des données provenant dudit réseau de circuits-registres (32);

ledit réseau de circuits-registres (32) est un réseau de circuits de verrouillage pouvant être rendus actifs chacun pour fournir des données à un premier bus de données $(DB_{(o)})$ et pour recevoir des données d'un deuxième bus de données $(DB_{(1)})$, lesdits premier et deuxième bus de données étant connectés à une entrée et à une sortie desdits moyens de modification de données (25a), respectivement, par des moyens de transfert de données;

lesdits moyens de transfert de données comprenant un premier réseau de portes (33), comportant des portes dans une correspondance univoque avec lesdits circuits de verrouillage (32), pour transférer des données à partir des circuits de verrouillage (32) vers ledit premier bus de données ($DB_{(o)}$) sous la commande d'un réseau de registres de commande (34), et un deuxième réseau de portes (35) comportant des portes dans une correspondance univoque avec lesdits circuits de verrouillage (32), pour transférer des données à partir dudit deuxième bus de données ($DB_{(1)}$) vers lesdits circuits de verrouillage sous la commande dudit réseau de registres de commande (34);

des transferts de données pouvant ainsi être réalisées, en fonctionnement, simultanément à partir du et vers ledit réseau de circuits de verrouillage (32) pour l'exécution d'une opération de lecture-modification-écriture rapide.

5. Dispositif de mémoire à semiconducteur selon l'une quelconque des revendications 1 à 4, dans lequel ledit circuit d'entrée et de sortie de données (10,11; 20a;20-1,...,20-n;31) comprenant au moins un groupe de portes, les portes étant connectées entre des fils de sélection de cellule de mémoire respectifs (BL) du réseau de cellules de mémoire (1,100) et ledit réseau de circuits-registres et commandées en commun par un circuit de commande de porte (16;26a;26).

6. Dispositif de mémoire à semiconducteur selon l'une quelconque des revendications 1 à 5, dans lequel les moyens de modification de données (15;25a;25-1 à 25-n;25a) comprennent un circuit à opération logique pour l'exécution d'une opération logique sur un bit de données.

7. Dispositif de mémoire à semiconducteur selon l'une quelconque des revendications 1 à 6, dans lequel les registres des moyens à registres sont sous la forme d'un ou plusieurs registres à décalage (12,14;21a;21-1, ...,21-n).

8. Dispositif de mémoire à semiconducteur selon l'une quelconque des revendications 1 à 6, dans lequel les registres des moyens à registres sont constitués par des bascules (32).

9. Dispositif de mémoire à semiconducteur selon la revendication 1, dans lequel:

ledit circuit d'entrée et de sortie de données comprend un groupe de premières portes (10) commandées en commun par un circuit de commande de porte (16);

un premier réseau de circuits-registres (12) est constitué par une pluralité de registres connectés en série;

une borne de chacune desdites premières portes(10) étant connectée activement à un fil de sélection de cellule de mémoire correspondant (BL) et son autre borne étant connectée à un registre correspondant desdits premiers registres (12);

dans un mode de transfert de données, chacun desdits premiers registres (12) pouvant être rendu actif indépendamment des autres, ledit circuit de commande de porte commandant simultanément ladite pluralité de premières portes (10) pour mémoriser simultanément une pluralité de données desdites cellules de mémoire dans lesdits premiers registres (12);

dans un mode de sortie de données, lesdits premiers registres (12) pouvant être rendus actifs en série pour sortir successivement les données qui y sont mémorisées vers lesdits moyens de transfert (13).

10. Dispositif de mémoire à semiconducteur selon l'une quelconque des revendications 2 à 4, dans lequel les moyens de transfert de données (22a,23a,DB;22-1,..., 22-n,23-1,...,23-n,DB1,...,DB-n;33,35,34,$DB_{(o)}$),$DB_{(1)}$) sont pourvus de moyens de sélection (23a;23-1,...,23-n; 34) pouvant être rendus actifs pour sélectionner un sous-groupe des registres des moyens à registres, pour exécuter l'opération de lecture-modification-écriture sur les données d'une zone prédéterminée de cellules de mémoire.

11. Dispositif de mémoire à semiconducteur selon l'une quelconque des revendications 2 et 3, dans lequel ledit réseau de circuits-registres de pointeur (23a; 23-1,...,23-n) est fourni par un registre à décalage qui est commandé par un décodeur (24a,24) de manière à rendre successivement actives les portes du réseau de portes de sortie (22a;22-1,...,22-n) en réponse à une instruction décodée dans ledit décodeur.

**Patentansprüche**

1. Halbleiterspeichervorrichtung mit:-

einem Speicherzellenarray (1) mit wahlfreiem Zugriff, das eine Vielzahl von Speicherzellen enthält;

Registereinrichtungen, die wenigstens ein Registerschaltungsarray (12,14) und eine Dateneingangs- und -ausgangsschaltung (10,11) zum parallelen Datentransfer zwischen dem Registerschaltungsarray und den Speicherzellen umfaßt, und ferner einen seriellen Dateneingang und einen seriellen Datenausgang umfaßt;

dadurch gekennzeichnet, daß:-

die Registereinrichtung ein erstes Registerschaltungsarray (12) umfaßt, zum Lesen von Daten in Speicherzellen, und ein zweites Registerschaltungsarray (14), zum Schreiben von Daten in die Speicherzellen;

Datenmodifizierungseinrichtungen (15) zum Modifizieren, in einem vorbestimmten logischen Betrieb von Daten von dem seriellen Datenausgang zu der Registereinrichtung vorgesehen sind;

der serielle Datenausgang der Registereinrichtung ist mit einem Eingang der Datenmodifizierungseinrichtung (15) über Transfereinrichtungen (13) verbunden ist, und ein Ausgang der Datenmodifizierungseinrichtung (15) mit dem seriellen Dateneingang der Registereinrichtung verbunden ist;

wodurch, im Betrieb, der Datentransfer von und zu der Registereinrichtung simultan durchgeführt werden kann, um einen Hochgeschwindigkeits-Lese-Modifizierungs-Schreibbetrieb durchzuführen.

2. Halbleiterspeichervorrichtung mit:-

einem Speicherzellenarray (100) mit wahlfreiem Zugriff, das eine Vielzahl von Speicherzellen enthält; und

Registereinrichtungen, die ein Registerschaltungsarray (21a; 21-1, ... 21-n) und eine Dateneingangs- und -ausgangsschaltung (20a; 20-1, ... 20-n) umfaßt, zum parallelen Datentransfer zwischen dem Registerschaltungsarray und den Speicherzellen, und ferner einen seriellen Dateneingang und einen seriellen Datenausgang umfaßt;

dadurch gekennzeichnet, daß:-

Datenmodifizierungseinrichtungen (25a; 25-1, ... 25-n) vorgesehen sind, um, in einem vorbestimmten logischen Betrieb, Daten von dem seriellen Datenausgang der Registereinrichtungen (21a; 21-1, ... 21-n) zu modifizieren, wobei der serielle Datenausgang der Registereinrichtung mit einem Eingang der Datenmodifizierungseinrichtung (25a; 25-1, ... 25-n) über Transfereinrichtungen (22a, 23a, DB; 22-1, ... 22-n, 23-1, ... 23-n, DB-1, ... DB-n) verbunden ist, und ein Ausgang, der Datenmodifizierungseinrichtung mit dem seriellen Dateneingang der Registereinrichtung (21a; 21-1, ... 21-n) verbunden ist;

und daß die genannte Transfereinrichtung ein Ausgangsgatterarray (22a; 22-1, ... 22-n), ein Zeigerregisterschaltungsarray (23a; 23-1, ...23-n) und einen Datenbus (DB; DB-1, ...DB-n) umfaßt, und das Ausgangsgatterarray Gatter umfaßt, die zwischen entsprechenden Registerschaltungen der Registereinrichtung (21a; 21-1, ...21-n) und dem genannten Datenbus verbunden sind und durch das Zeigerregisterschaltungsarray (23a; 23-1, ...23-n) gesteuert werden;

wodurch, im Betrieb, der Datentransfer von und zu der genannten Registereinrichtung (21a; 21-1, ...21-n) durchgeführt werden kann, um einen Hochgeschwindigkeits-Lese-Modifizierungs-Schreibbetrieb zu bewirken.

3. Halbleiterspeichervorrichtung nach Anspruch 2, bei der die Datenmodifizierungseinrichtung eine Vielzahl von Modifizierungsschaltungen (25-1, ...25-n) umfaßt, die parallel zueinander vorgesehen sind, und bei der die Registereinrichtung in Form einer Vielzahl von Schieberegistern (21-1, ...21-n) ist, von denen eine oder mehrere für jede entsprechende Modifizierungsschaltung vorgesehen sind, wobei jede Modifizierungsschaltung eine individuelle Datentransfereinrichtung (22-1, ...22-n, 23-1, ...23-n, DB-1, ...DB-n) hat, die sie mit ihrem entsprechenden Schieberegister verbindet, wodurch ein Hochgeschwindigkeits-Schreib-Lese-Modifizierungsbetrieb in paralleler Weise durch jede Modifizierungsschaltung durchgeführt werden kann.

4. Halbleiterspeichervorrichtung mit:-

einem Speicherzellenarray mit wahlfreiem Zugriff, welches eine Vielzahl von Speicherzellen enthält, und

Registereinrichtungen, die ein Registerschaltungsarray (32) und eine Dateneingangs- und -ausgangsschaltung (31) für einen parallelen Datentransfer zwischen dem Registerschaltungsarray und den Speicherzellen umfaßt;

dadurch gekennzeichnet, daß:-

Datenmodifikationseinrichtungen (25a) vorgesehen sind, um, in einem vorbestimmten logischen Betrieb, Daten von dem Registerschaltungsarray (32) zu modifizieren;

das Registerschaltungsarray (32) ein Array von Halteschaltungen ist, die jeweils betreibbar sind, um Daten an einen ersten Datenbus ($DB_{(o)}$) zu liefern und Daten von einem zweiten Datenbus ($DB_{(1)}$) zu empfangen, wobei die ersten und zweiten Datenbusse über die Gatentransfereinrichtungen mit einem Eingang, bzw. einem Ausgang der genannten Datenmodifizierungseinrichtung (25a) verbunden sind;

die genannte Datentransfereinrichtung ein erstes Array von Gattern (33) umfaßt, die Gatter in einer eins-zu-eins-Entsprechung mit den Halteschaltungen (32) haben, um Daten unter der Steuerung eines Steuerregisterarrays (34) von den Halteschaltungen (32) zu dem ersten Datenbus ($DB_{(0)}$) zu transferieren, und ein zweites Array von Gattern (35), die Gatter in einer eins-zu-eins-Entsprechung mit den genannten Halteschaltungen (32) haben, um Daten unter der Steuerung des Steuerregisterarrays (34) von dem genannten zweiten Datenbus ($DB_{(1)}$) zu den Halteschaltungen zu transferieren;

wodurch, im Betrieb, Datentransfers von und zu den genannten Arrays der Halteschaltungen (32) simultan durchgeführt werden können, um einen Hochgeschwindigkeits-Lese-Modifizierungs-Schreibbetrieb zu bewirken.

5. Halbleiterspeichervorrichtung nach einem der vorhergehenden Ansprüche, bei der die genannte Dateneingangs- und -ausgangsschaltung (10, 11; 20a; 20-1, ...20-n; 31) wenigstens einen Satz von Gattern umfaßt, welche Gatter zwischen entsprechenden Speicherzellen-Auswahlleitungen (BL) des Speicherzellenarrays (1, 100) und dem Registerschaltungsarray angeordnet und gemeinsam durch eine Gattertreiberschaltung (16; 26a; 26) gesteuert werden.

6. Halbleiterspeichervorrichtung nach einem der vorhergehenden Ansprüche, bei der die Datenmodifizierungseinrichtung (15; 25a; 25-1 bis 25-n; 25a) eine logische Betriebsschaltung zur Durchführung eines logischen Betriebs auf ein-Bit-Daten umfaßt.

7. Halbleiterspeichervorrichtung nach einem der vorhergehenden Ansprüche, bei der die Register der Registereinrichtung in Form von einem oder mehreren Schieberegistern (12, 14; 21a; 21-1, ...21-n) vorhanden sind.

8. Halbleiterspeichervorrichtung nach einem der Ansprüche 1 bis 6, bei der die Register der Registereinrichtung durch Flipflops (32) gebildet sind.

9. Halbleiterspeichervorrichtung nach Anspruch 1, bei der:-

die Dateneingangs- und -ausgangsschaltung einen Satz von ersten Gattern (10) umfaßt, die gemeinsam durch eine Gattertreiberschaltung (16) gesteuert werden;

ein erstes Registerschaltungsarray (12) durch eine Vielzahl von Registern gebildet ist, die in Reihe miteinander verbunden sind;

ein Anschluß von jedem der genannten ersten Gatter (10) wirkungsmäßig mit einer entsprechenden Speicherzellen-Auswahlleitung (BL) verbunden ist, und ein anderer Anschluß derselben mit einem entsprechenden der ersten Register (12) verbunden ist;

bei einem Datentransfermodus jedes der ersten Register (12) unabhängig von jedem anderen betreibbar ist, die Gattertreiberschaltung gleichzeitig die genannte Vielzahl von ersten Gattern (10) treibt, um gleichzeitig eine Vielzahl von Daten der Speicherzellen in die ersten Register (12) zu speichern;

bei einem Datenausgangsmodus die ersten Register (12) seriell betreibbar sind, um nacheinander darin gespeicherte Daten zu der Transfereinrichtung (13) auszugeben.

10. Halbleiterspeichervorrichtung nach den Ansprüchen 2, 3 oder 4, bei der die Datentransfereinrichtung (22a, 23a, DB; 22-1, ...22-n, 23-1, ...23-n, DB1, ...DB-n; 33, 35, 34, $DB_{(o)}$, $DB_{(1)}$) mit Auswahleinrichtungen (23a; 23-1 ...23-n; 34) versehen ist, die betreibbar sind, um eine Untermenge der Register der Registereinrichtung auszuwählen, um den Lese-Modifizierungs-Schreibbetrieb auf den Daten in einem vorbestimmten Bereich der Speicherzellen durchzuführen.

11. Halbleiterspeichervorrichtung nach Anspruch 2 oder 3, bei der das Zeigerregisterschaltungsarray (23a; 23-1, ...23-n) durch ein Schieberegister vorgesehen ist, welches durch einen Dekoder (24a, 24) gesteuert wird, um so sukzessive die Gatter des Ausgangsgatterarrays (22a; 22-1, ...22-n) in Abhängigkeit von einem Befehl zu aktivieren, der bei dem anderen Dekoder dekodiert wurde.

Fig. 1

*EP 0 188 059 B1*

## Fig. 2

## Fig. 3

$$N14 \rightarrow N21, N22 \rightarrow N23, N24$$

## Fig. 4

*Fig. 5a*

$S_{IN}$
$S_{OUT}$

*Fig. 5b*

$S_{IN}$
$S_{OUT}$

*Fig. 5c*

$S_{OUT}$

*Fig. 6*

# Fig. 7

# Fig. 8

Fig. 9

Fig. 10

Fig. 11

17

# Fig. 12

Fig. 13

EP 0 188 059 B1

Fig. 14